# EUROPÄISCHE PATENTSCHRIFT

(11) **EP 4 190 138 B1**
(45) Veröffentlichungstag und Bekanntmachung des Hinweises auf die Patenterteilung: **04.11.2026**
(21) Anmeldenummer: 21769068.4
(22) Anmeldetag: 19.08.2021
(51) Int. Cl.: H05K 7/20

(54) **KÜHLKÖRPER-ANORDNUNG UND STROMRICHTERANORDNUNG**
COOLING BODY ASSEMBLY AND POWER CONVERTER ASSEMBLY
AGENCEMENT DE DISSIPATEUR THERMIQUE ET AGENCEMENT DE CONVERTISSEUR

(30) Priorität: 23.10.2020 EP 20203605
(43) Veröffentlichungstag der Anmeldung: 07.06.2023
(73) Patentinhaber: Siemens Aktiengesellschaft, 80333 München (DE)
(72) Erfinder: KÖGLER, Roman, 90403 Nürnberg (DE); NAMYSLO, Lutz, 91353 Hausen (DE); SCHWINN, Thomas, 91074 Herzogenaurach (DE)
(74) Vertreter: Siemens Patent Attorneys
(86) Internationale Anmeldenummer: PCT/EP2021/073020
(87) Internationale Veröffentlichungsnummer: WO 2022/083920

(56) Entgegenhaltungen:
- JP-A- H07 249 885
- US-A1- 2012 014 066
- US-A1- 2014 014 308

## Beschreibung

Die Erfindung betrifft eine Kühlkörper-Anordnung für mehrere Halbleiter-Bauelemente, umfassend einen ersten Kühlkörper und einen zweiten Kühlkörper mit jeweils einer Bauelemente-Seite und einer mit Kühlrippen bestückten Kühlrippen-Seite, welche derart hintereinander angeordnet sind, dass ein Kühlmedium in einer Strömungsrichtung zunächst durch Kühlkanäle, welche durch die Kühlrippen des ersten Kühlkörpers gebildet sind, und dann durch Kühlkanäle, welche durch die Kühlrippen des zweiten Kühlkörpers gebildet sind, strömt.

Eine Kühlkörper-Anordnung mit mehr als zwei hintereinander angeordneten Kühlkörpern ist ebenso denkbar.

Des Weiteren betrifft die Erfindung eine Stromrichter-Anordnung zur Versorgung einer elektrischen Maschine, umfassend die eingangs genannte Kühlkörper-Anordnung.

Aus der Praxis ist es bekannt und üblich, zur Kühlung von Halbleiter-Bauelementen, Kühlkörper einzusetzen. Aus der EP 0 340 520 B1 ist eine Anordnung zur konvektiven Kühlung von Bauelementen bekannt, die einen Kühlkörper aufweist, der aus zwei übereinander angeordneten Teilen zusammengesetzt ist.

Aus fertigungstechnischen Gründen und aufgrund eines einfacheren konstruktiven Aufbaus und/oder einer platzsparenden Anordnung, beispielsweise in Stromrichter-Anordnungen, insbesondere eines Umrichters, werden die Halbleiter-Bauelemente, welche zur Ansteuerung eines Motors benötigt werden, oft auf einen gemeinsamen Kühlkörper zur Entwärmung angeordnet. Diese Halbleiter-Bauelemente sind in Bezug auf eine Richtung eines Kühlmedium-Flusses nacheinander platziert, wodurch eine thermische Reihenschaltung entsteht. Diese thermische Reihenschaltung führt zu einer abnehmenden Kühlwirkung, je weiter das jeweilige zu kühlende Halbleiter-Bauelement von einem Einlass des Kühlmediums entfernt ist.

In der US 2012/014066 A1, JP H07 249885 A und US 2014/014308 A1 sind bereits derartige Kühlkörper offenbart.

Es ist Aufgabe der Erfindung die bekannten Anordnungen zur Kühlung von Halbleiter-Bauelementen zu vereinfachen, damit ein Kühlmedium auch bei weiter von einem Einlass entfernt liegenden zu kühlenden Bauteilen noch eine ausreichende Temperatur hat um damit eine ausreichende Kühlleistung für das vom Einlass weiter entfernte Bauteil zu erbringen.

Die eingangs genannte Aufgabe wird dadurch gelöst, dass ein erster Einlassquerschnitt, welcher sich auf einer Einlassseite des ersten Kühlkörpers durch Einzelquerschnitte der zugehörigen Kühlkanäle, des ersten Kühlkörpers zusammensetzt, mittels eines Abschottungsmittels, welches die Kühlkanäle auf der Einlassseite des ersten Kühlkörpers zumindest teilweise abdeckt, gegenüber einem zweiten Einlassquerschnitt, welcher sich auf einer Einlassseite des zweiten Kühlkörpers durch Einzelquerschnitte der zugehörigen Kühlkanäle des zweiten Kühlkörpers zusammensetzt, reduziert ist, wobei das Abschottungsmittel als ein Kamm zum Einstecken in die Einlassseite des ersten Kühlkörpers ausgestaltet ist.

Da eine Parallelschaltung der beiden Kühlkörper aufgrund von Kompatibilitäten, z.B. bei bestehenden Umrichterreihen, mit einer definierten Kundenschnittstelle nicht möglich ist, sind die beiden Kühlkörper hintereinandergeschaltet. Der erste Kühlkörper könnte als der thermisch kühlere Kühlkörper bezeichnet werden und der zweite Kühlkörper kann als der thermisch wärmere Kühlkörper bezeichnet werden.

Erfindungsgemäß wird bei dem kühleren Kühlkörper durch eine thermische Teilentkopplung einzelner Kühlzwischenräume angewendet, dadurch wird seine Gesamtkühlleistung verschlechtert. Bei einem gleichen Volumenstrom, beispielsweise durch einen Lüfter bei einer forcierten Konvektion, erhöht sich ein Druck in einem Stauraum des Lüfters und der Volumenstrom in den verbleibenden "offenen" Kühlkanälen wird erhöht. Das aus dem kühleren Kühlkörper ausströmende Kühlmedium ist nun kühler als bei einer herkömmlichen Reihenschaltung, bei welchen kein Abschottungsmittel in dem ersten Kühlkörper eingesetzt ist. Demzufolge erhöht sich bei dem ersten Kühlkörper die statische Temperatur. Dies entspricht einer "Verschlechterung" der Entwärmung des mit beispielsweise einem Kunststoffkamm bestückten Kühlkörpers. Der Kunststoff muss die Kühlrippen nicht vollständig verschließen, auch Kamm-Teilunterbrechungen, Löcher sind denkbar.

Auch eine segmentale Teilabschottung eines Kühlkanals über beispielsweise konisch zulaufende Einlagen über die gesamte Rippenlänge ist denkbar.

Mit dieser Maßnahme kann man eine Anzahl von aktiven an der Kühlung beteiligten Kühlrippen beeinflussen.

Eine besonders vorteilhafte Weiterbildung der Kühlkörper-Anordnung sieht vor, dass zwischen dem ersten Kühlkörper und dem zweiten Kühlkörper ein Zwischenraum angeordnet ist, welcher mittels einer Abdeckung abgedeckt ist, wobei der Zwischenraum und die Abdeckung eine Verwirbelungskammer bilden.

Einzelne Ströme aus den Kühlkanälen des ersten Kühlkörpers können nun in dem Zwischenraum verwirbeln und zu neuen Strömen für den zweiten Kühlkörper, in die, in der Regel gänzlich offenen, Kühlkanäle einströmen. Der Zwischenraum mit seiner Abdeckung fungiert als eine Art Diffusor für das Kühlmedium. Um dem zweiten in Reihe geschalteten Kühlkörper das aus dem ersten Kühlkörper ausströmende Kühlmedium gleichmäßig auf alle Kühlrippen bzw. Kühlkanäle zur Verfügung zu stellen, wird der Vorraum benötigt, der die Verwirbelung und gleichmäßige Verteilung des Kühlmediums sicherstellt.

In dem Zwischenraum werden für eine verbesserte Verwirbelung Verwirbelungs- und/oder Leitelemente angeordnet.

Durch Einbringen eines Kunststoffteils zwischen den beiden Kühlkörpern kann der Zwischenraum abgedeckt werden. Dieser Zwischenraum dient zur gleichmäßigen Verteilung des Kühlmediums auf die anderen Kühlkanäle des zweiten Kühlkörpers. Das Kunststoffteil kann in einer vorteilhaften Ausführung so gestaltet sein, dass es intern eine Struktur aufweist, die die notwendige optimale Verwirbelung und Kühlmittelmedium-Umlenkung übernimmt. Verwirbelungselemente könnten beispielsweise als Strömungsleitbleche oder tragflächenförmig oder wie ein Spoiler, ausgestaltet sein.

Die eingangs genannte Aufgabe wird ebenso durch eine Stromrichteranordnung zur Versorgung einer elektrischen Maschine gelöst. Die Stromrichteranordnung umfasst dabei eine Kühlkörper-Anordnung für mehrere Halbleiter-Bauelemente umfassend, einen ersten Kühlkörper und einen zweiten Kühlkörper mit jeweils einer Bauelemente-Seite und einer mit Kühlrippen bestückten Kühlrippenseite, welche derart hintereinander angeordnet sind, dass ein Kühlmedium in einer Strömungsrichtung zunächst durch die Kühlkanäle, welche durch die Kühlrippen des ersten Kühlkörpers gebildet sind, und dann durch die Kühlkanäle, welche durch die Kühlrippen des zweiten Kühlkörpers gebildet sind, strömt. Dabei wird ein erster Einlassquerschnitt, welcher sich auf einer Einlassseite des ersten Kühlkörpers durch Einzelquerschnitte der zugehörigen Kühlkanäle, des ersten Kühlkörpers zusammensetzt, mittels eines Abschottungsmittels, welches die Kühlkanäle, auf der Einlassseite des ersten Kühlkörpers zumindest teilweise abdeckt, gegenüber einem zweiten Einlassquerschnitt, welcher sich auf einer Einlassseite des zweiten Kühlkörpers durch Einzelquerschnitte der zugehörigen Kühlkanäle des zweiten Kühlkörpers zusammensetzt, reduziert, wobei das Abschottungsmittel als ein Kamm zum Einstecken in die Einlassseite des ersten Kühlkörpers ausgestaltet ist.

Um die Entwärmung der Anordnung weiterhin zu verbessern, ist zwischen dem ersten Kühlkörper und dem zweiten Kühlkörper ein Zwischenraum angeordnet, welcher mittels einer Abdeckung abgedeckt ist, wobei der Zwischenraum und die Abdeckung eine Verwirbelungskammer bilden.

Insbesondere in Bezug auf Umrichter für die Steuerung von elektrischen Maschinen ist die Stromrichter-Anordnung vorgesehen zum senkrechten Einbau in einen Schaltschrank, wobei eine Längsachse der Kühlkörper-Anordnung vertikal angeordnet ist und damit die Strömungsrichtung durch die Stromrichter-Anordnung parallel zur Längsachse entsteht und ein Einlass für ein Kühlmedium unten an der Einlassseite des ersten Körpers angeordnet ist und ein Auslass für das Kühlmedium oben über der der Einlassseite des zweiten Kühlkörpers gegenüberliegenden Auslassseite angeordnet ist.

Mit Vorteil wird nun für derart bautechnisch gestaltete Stromrichter-Anordnungen kein zusätzlicher Bypass mehr für die Kühlkörper-Anordnung benötigt, dieser zusätzliche Bypass würde nur das restliche zur Verfügung stehende Gerätevolumen, welches besser zur Unterbringung elektronischer und mechanischer Komponenten benötigt wird, reduzieren. Folglich besteht der notwendige Bauraum für weitere Gerätebauteile, wie Sicherung, Zwischenkreiskondensatoren nun zur Verfügung.

Die zuvor verwendeten preisintensiven teureren Bypass-Bauteile werden nicht mehr benötigt und ein Geräteaufbau einer Stromrichter-Anordnung konstruktiv, sowie montageseitig vereinfacht. In Abhängigkeit von der Ausführung des Abschottungsmittels bzw. Einschubkammes (Anzahl der verschlossenen Kühlkanäle) und des zwischen den Kühlkörpern vorhandenen Stauraumes, kann die Entwärmung der beiden in Reihe geschalteten Kühlkörper so optimiert werden, dass beide Kühlkörper annähernd eine gleiche Temperatur im Betrieb erreichen. Dies führt zu einer Erhöhung einer Lebensdauer der Stromrichter-Anordnung, da ohne die oben genannten Maßnahmen der thermisch wärmere Kühlkörper lebensdauerbestimmend für die Halbleiter-Bauelemente ist. Auch eine Kostenreduktion aufgrund des Einsatzes gegebenenfalls kleinerer Leistungshalbleiter wäre denkbar, da die Halbleiterclips nicht mehr auf den heißeren im Luftkanal sekundär durchströmenden Kühlkörper ausgelegt werden müssen.

Die Zeichnung zeigt ein Ausführungsbeispiel, wobei die
- FIG 1: eine Kühlkörper-Anordnung zum Kühlen von Halbleiterbauteilen zeigt,
- FIG 2: die Kühlkörper-Anordnung in einer anderen perspektivischen Ansicht mit einer Draufsicht auf eine Kühlrippenseite,
- FIG 3: die aus FIG 2 bekannte Kühlkörper-Anordnung mit Augenmerk auf einen Zwischenraum,
- FIG 4: eine Abdeckung für den Zwischenraum,
- FIG 5: die Abdeckung aus FIG 4 in einer anderen perspektivischen Darstellung,
- FIG 6: einen Kamm als Abschottungsmittel,
- FIG 7: eine Verdeutlichung der effektiven Einlassquerschnitte,
- FIG 8: eine Verdeutlichung der Verwirbelung von Strömungslinien in dem Zwischenraum und
- FIG 9: eine Stromrichter-Anordnung in einem Schaltschrank.

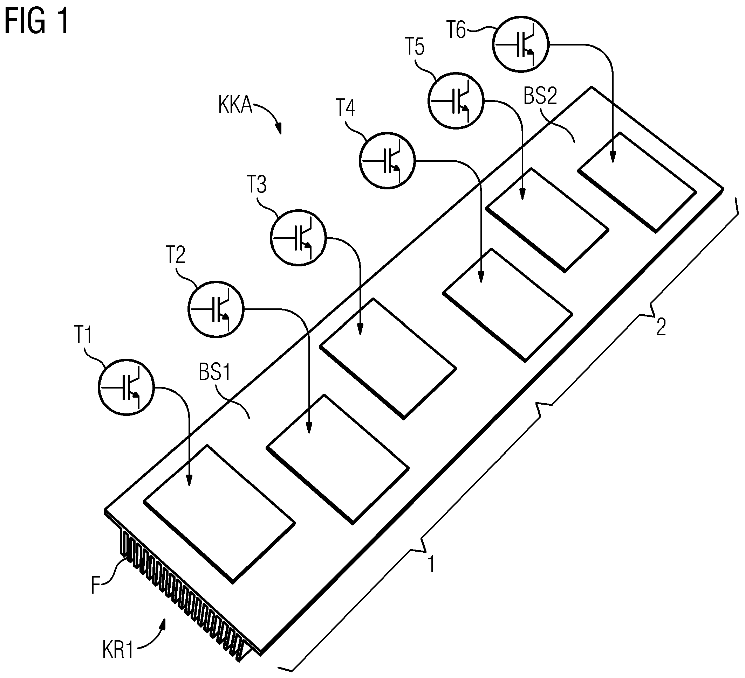

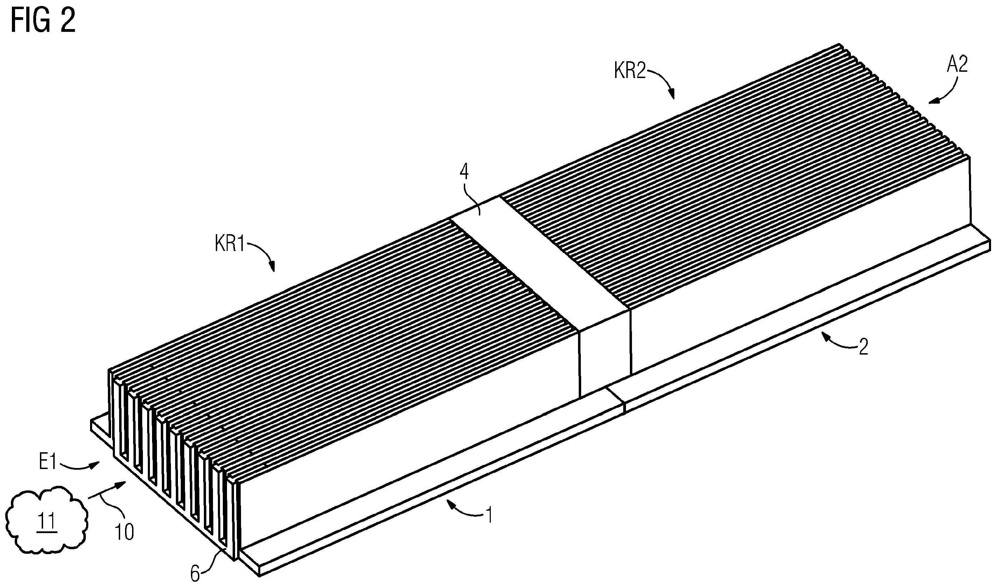

Gemäß FIG 1 ist eine Kühlkörper-Anordnung KKA für mehrere Halbleiter-Bauelemente T1,...,T6 gezeigt. Die Kühlkörper-Anordnung KKA umfasst einen ersten Kühlkörper 1 und einen zweiten Kühlkörper 2 mit jeweils einer Bauelemente-Seite BS1,BS2 auf welchen die Halbleiter-Bauelemente T1,...,T6 zur Kühlung platziert werden können. Den Bauelemente-Seiten BS1,BS2 liegt jeweils eine mit Kühlrippen F bestückte Kühlrippenseite KR1,KR2 gegenüber. Die Kühlrippen F sind derart hintereinander angeordnet, dass ein Kühlmedium 11 in einer Strömungsrichtung 10 gemäß FIG 2 zunächst durch die Kühlkanäle K1i, welche durch die Kühlrippen F des ersten Kühlkörpers 1 gebildet sind, und dann durch die Kühlkanäle K2i, welche durch die Kühlrippen F des zweiten Kühlkörpers 2 gebildet sind, strömt.

FIG 2 zeigt die Kühlkörper-Anordnung KK1 mit Blick auf die Kühlrippenseiten KR1,KR2.

Das Kühlmedium 11 kann an einer ersten Einlassseite E1 in die Kühlkörper-Anordnung KKA eintreten und über eine Auslassseite A2 des zweiten Kühlkörpers 2 wieder austreten. Eine Abdeckung 4 verbindet die beiden Kühlkörper 1,2 strömungstechnisch miteinander. Mittels eines Kammes 6 wird ein Querschnitt der ersten Einlassseite E1 verkleinert.

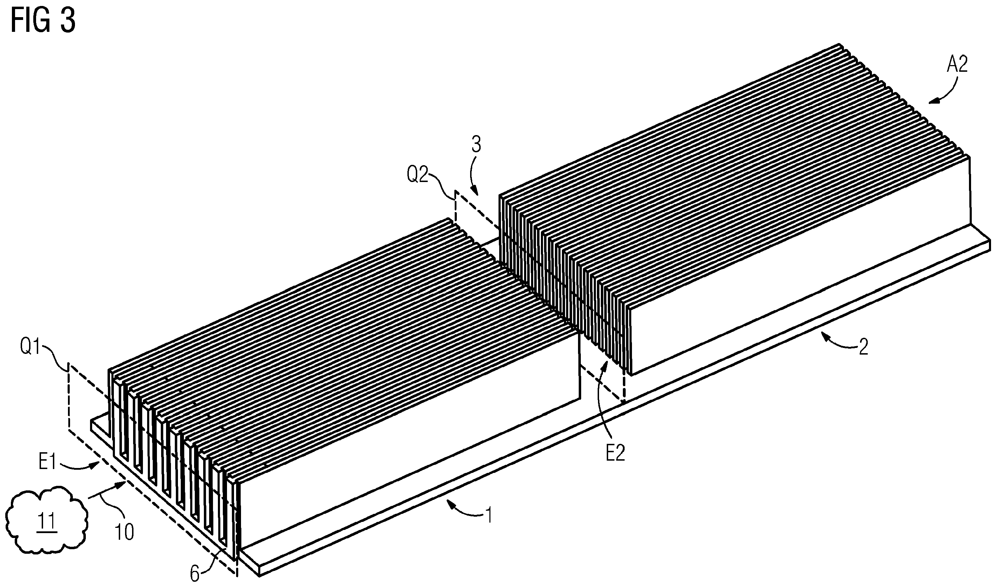

FIG 3 zeigt wie sich ein erster Einlassquerschnitt Q1, welcher sich auf der Einlassseite E1 des ersten Kühlkörpers 1 durch Einzelquerschnitte EQK1i der zugehörigen Kühlkanäle K1i, des ersten Kühlkörpers, zusammensetzt. Mittels des Kammes 6, welcher die Kühlkanäle K1i auf der Einlassseite E1 des ersten Kühlkörpers 1 zumindest teilweise abdeckt, wird gegenüber einem zweiten Einlassquerschnitt Q2 (siehe FIG 3), welcher sich auf einer Einlassseite E2 des zweiten Kühlkörpers 2 durch Einzelquerschnitte EQK2i der zugehörigen Kühlkanäle K2i des zweiten Kühlkörpers 2 zusammensetzt, der erste Einlassquerschnitt Q1 reduziert.

Zwischen dem ersten Kühlkörper 1 und dem zweiten Kühlkörper 2 ist gemäß FIG 3 ein Zwischenraum 3 angeordnet. Der Zwischenraum 3 ist gemäß FIG 2 mit einer Abdeckung 4 abgedeckt. Der Zwischenraum 3 und die Abdeckung 4 bilden eine Verwirbelungskammer. Der abgedeckte Zwischenraum 3 dient zur gleichmäßigen Verteilung des Kühlmediums 11 auf alle Kühlkanäle K2i des zweiten Kühlkörpers 2.

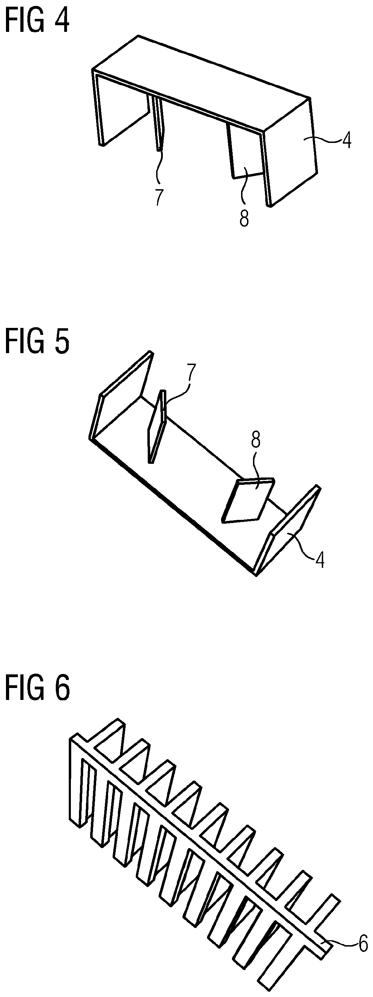

Die FIG 4 und FIG 5 zeigen die Abdeckung 4, wobei die Abdeckung 4 mit einem ersten Leitelement 7 und einem zweiten Leitelement 8 versehen ist.

Mit der FIG 6 ist das Abschottungsmittel in Form eines Kammes 6 dargestellt. Die einzelnen Kammelemente sind derart ausgestaltet, dass sie genau in den Zwischenraum von zwei Kühlrippen F passen und somit einen Kühlkanal abschotten können.

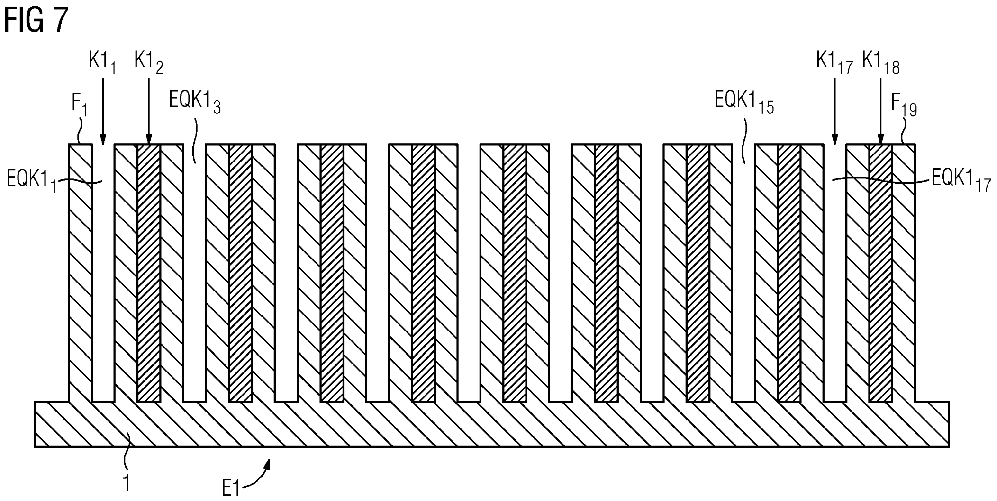

Mit der FIG 7 wird die Reduzierung des ersten Einlassquerschnittes Q1 gegenüber des zweiten Einlassquerschnittes Q2 veranschaulicht. Mit Blick auf die Kühlrippen F1,..., F19 des ersten Kühlkörpers 1 sind auch die jeweiligen Kühlkanäle K1₁,K1₂,...,K1₁₇,K1₁₈ zu sehen. Mittels des Kamms 6, welcher in die Kühlkanäle K1i gesteckt ist, werden jeweils die Kühlkanäle K1i mit einem geraden Index verschlossen. Die Kühlkanäle K1i mit einem ungeraden Index bleiben offen. Für einen ersten Einlassquerschnitt Q1 ergibt sich demnach die Formel $Q 1 = {\sum }_{1 \leq i \leq 9} EQK 1 \left(2i-1\right)$ und für einen zweiten dahinterliegenden Einlassquerschnitt des zweiten Kühlkörpers 2, bei welchem keiner der Kühlkanäle K2i verschlossen ist, ergibt sich für den zweiten Einlassquerschnitt Q2 die Formel $Q 2 = {\sum }_{1 \leq i \leq 18} EQK 2 \left(i\right)$

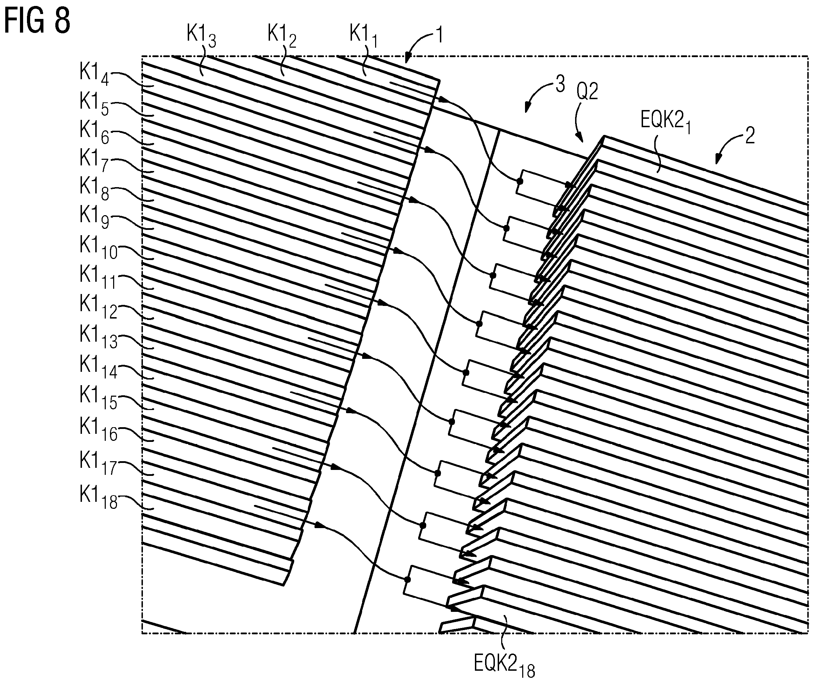

Mit der FIG 8 wird die erwähnte Verwirbelung der Strömung des Kühlmediums 11 in den Zwischenraum 3 verdeutlicht. Aufgrund des gesteckten Kammes 6 auf der Einlassseite E1 des ersten Kühlkörpers 1, kann nur aus den Kühlkanälen K1i mit ungeraden Index ein Kühlmediumteilstrom herausströmen. Die sich ergebenden neun ausströmenden Teilströme verteilen sich dann auf die Kühlkanäle K2i des zweiten Kühlkörpers 2, wobei dieser dann vollständig mit dem Kühlmedium 11, welches sich im ersten Kühlkörper noch nicht vollständig aufgeheizt hat, durchströmt werden.

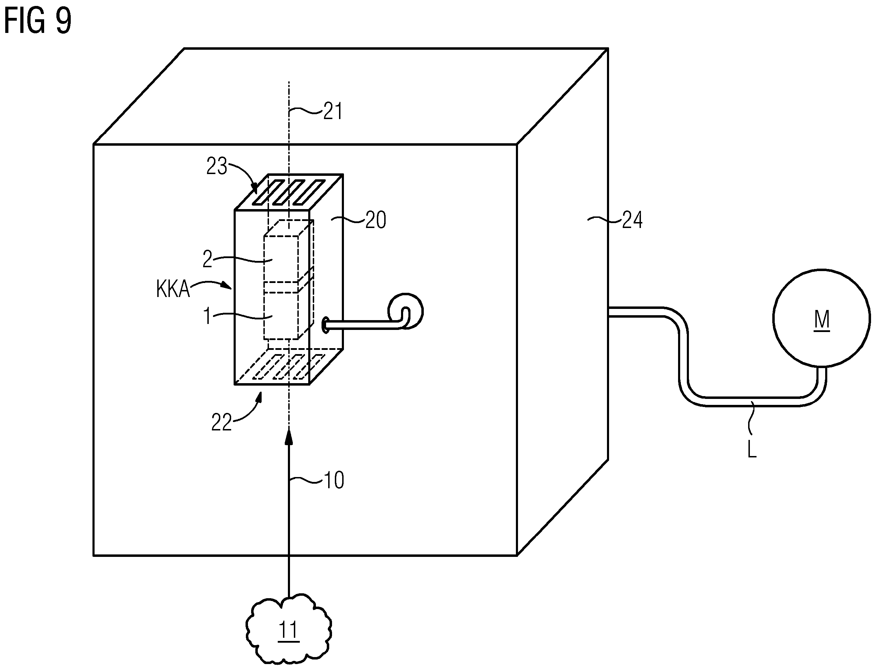

Gemäß FIG 9 ist eine Stromrichter-Anordnung 20 zur Versorgung einer elektrischen Maschine M in einem Schaltschrank 24 dargestellt. Eine Längsachse 21 der Stromrichter-Anordnung 20 bzw. der innen integrierten Kühlkörper-Anordnung KKA ist vertikal angeordnet und damit ist die Strömungsrichtung 10 durch die Stromrichter-Anordnung 20 parallel zur Längsachse 21 und ein Einlass 22 für das Kühlmedium 11 ist unten angeordnet und ein Auslass 23 für das Kühlmedium 11 ist oben angeordnet. Bei der Stromrichter-Anordnung 20 ist ein erster Kühlkörper 1 und ein weiterer, im Wesentlichen identischer Kühlkörper 2, zur Kühlung der Bauelemente hintereinander in Strömungsrichtung 10 angeordnet. Die Stromrichter-Anordnung 20 kann über eine Leitung L den Motor M steuern.

Durch Einsatz der erfindungsgemäßen Kühlkörper-Anordnung KKA, wobei bei dem ersten Kühlkörper 1 der Einlassquerschnitt Q1 durch ein Abschottungsmittel reduziert wurde, kann eine derartige Stromrichter-Anordnung 20 mit Vorteil in einer kleinen baulichen Abmessung ausgestaltet werden, weil es möglich ist, die hintereinander geschalteten Halbleiter-Bauelemente T1,...,T6 mit der erfindungsgemäßen Kühlkörper-Anordnung KKA effizient zu entwärmen.

## Patentansprüche

1. Kühlkörper-Anordnung (KKA) für mehrere Halbleiter-Bauelemente (T1,..,T6) umfassend einen ersten Kühlkörper (1) und einen zweiten Kühlkörper (2) mit jeweils einer Bauelemente-Seite (BS1,BS2) und einer mit Kühlrippen (F) bestückten Kühlrippenseite (KR1,KR2), welche derart hintereinander angeordnet sind, dass ein Kühlmedium (11) in einer Strömungsrichtung (10) zunächst durch Kühlkanäle (K1i), welche durch die Kühlrippen (F) des ersten Kühlkörpers (1) gebildet sind, und dann durch Kühlkanäle (K2i), welche durch die Kühlrippen (F) des zweiten Kühlkörpers (2) gebildet sind, strömt, wobei
- ein erster Einlassquerschnitt (Q1), welcher sich auf einer Einlassseite (E1) des ersten Kühlkörpers (1) durch Einzelquerschnitte (EQK1i) der zugehörigen Kühlkanäle (K1i), des ersten Kühlkörpers (1) zusammensetzt, mittels eines Abschottungsmittels, welches die Kühlkanäle (K1i) auf der Einlassseite (E1) des ersten Kühlkörpers (1) zumindest teilweise abdeckt, gegenüber
- einem zweiten Einlassquerschnitt (Q2), welcher sich auf einer Einlassseite (E2) des zweiten Kühlkörpers (2) durch Einzelquerschnitte (EQK2i) der zugehörigen Kühlkanäle (K2i) des zweiten Kühlkörpers (2) zusammensetzt, reduziert ist,
**dadurch gekennzeichnet, dass**
das Abschottungsmittel als ein Kamm (6) zum Einstecken in die Einlassseite (E1) des ersten Kühlkörper (1) ausgestaltet ist.

2. Kühlkörper-Anordnung (KKA) nach Anspruch 1, wobei zwischen dem ersten Kühlkörper (1) und dem zweiten Kühlkörper (2) ein Zwischenraum (3) angeordnet ist, welcher mittels einer Abdeckung (4) abgedeckt ist, wobei der Zwischenraum (3) und die Abdeckung (4) eine Verwirbelungskammer bilden.

3. Kühlkörper-Anordnung (KKA) nach Anspruch 2, wobei in dem Zwischenraum (3) Verwirbelungs- und/oder Leitelemente angeordnet sind.

4. Stromrichteranordnung (20) zur Versorgung einer elektrischen Maschine (M) umfassend eine Kühlkörper-Anordnung (KKA) nach einem der Ansprüche 1 bis 3.

5. Stromrichteranordnung (20) nach Anspruch 4, vorgesehen zum senkrechten Einbau in einen Schaltschrank (24), wobei eine Längsachse (21) der Kühlkörper-Anordnung (KKA) vertikal angeordnet ist und damit die Strömungsrichtung (10) durch die Stromrichter-Anordnung (20) parallel zur Längsachse (21) entsteht und ein Einlass (22) für ein Kühlmedium unten an der Einlassseite (E1) des ersten Kühlkörper (1) angeordnet ist und ein Auslass (23) für das Kühlmedium (11) oben über der der Einlassseite (E2) des zweiten Kühlkörpers (2) gegenüberliegenden Auslassseite angeordnet ist.

## Claims

1. Heat sink assembly (KKA) for a plurality of semiconductor components (T1,..,T6) comprising a first heat sink (1) and a second heat sink (2) each having a component side (BS1,BS2) and a cooling fin side (KR1,KR2) equipped with cooling fins (F), which are arranged in series such that a coolant (11) flows in a direction of flow (10) first through cooling channels (K1i) formed by the cooling fins (F) of the first heat sink (1) and then through cooling channels (K2i) formed by the cooling fins (F) of the second heat sink (2), wherein
- a first inlet cross section (Q1), which, on an inlet side (E1) of the first heat sink (1), is composed of individual cross sections (EQK1i) of the associated cooling channels (K1i) of the first heat sink (1), is reduced by means of a partition means, which at least partially covers the cooling channels (K1i) on the inlet side (E1) of the first heat sink (1), in comparison with
- a second inlet cross section (Q2), which, on an inlet side (E2) of the second heat sink (2), is composed of individual cross sections (EQK2i) of the associated cooling channels (K2i) of the second heat sink (2),
**characterized in that**
the partition means is embodied as a comb (6) for insertion into the inlet side (E1) of the first heat sink (1).

2. Heat sink assembly (KKA) according to claim 1, wherein an interspace (3), which is covered by means of a cover (4), is arranged between the first heat sink (1) and the second heat sink (2), wherein the interspace (3) and the cover (4) form a turbulence chamber.

3. Heat sink assembly (KKA) according to claim 2, wherein turbulence and/or guidance elements are arranged in the interspace (3).

4. Power converter assembly (20) for supplying an electrical machine (M) comprising a heat sink assembly (KKA) according to one of claims 1 to 3.

5. Power converter assembly (20) according to claim 4 intended for vertical installation in a switchgear cabinet (24), wherein a longitudinal axis (21) of the heat sink assembly (KKA) is arranged vertically and thus the direction of flow (10) through the power converter assembly (20) is parallel to the longitudinal axis (21) and an inlet (22) for a coolant is arranged at the bottom on the inlet side (E1) of the first heat sink (1) and an outlet (23) for the coolant (11) is arranged at the top above the outlet side opposite the inlet side (E2) of the second heat sink (2).

## Revendications

1. Agencement (KKA) de puits de chaleur pour plusieurs composants (T1, ..., T6) à semiconducteur, comprenant un premier puits (1) de chaleur et un deuxième puits (2) de chaleur ayant chacun une face (BS1, BS2) de composants et une face (KR1, KR2) à ailettes de refroidissement équipée d'ailettes (F) de refroidissement, qui sont disposées l'une derrière l'autre, de manière à ce qu'un fluide (11) réfrigérant passe dans un sens (10) d'écoulement d'abord par des canaux (K1i) de refroidissement, qui sont formés par les ailettes (F) de refroidissement du premier puits (1) de chaleur, et ensuite par des canaux (K2i) de refroidissement, qui sont formés par les ailettes (F) de refroidissement du deuxième puits (2) de chaleur, dans lequel
- une première section (Q1) transversale d'entrée, qui se compose, sur une face (E1) d'entrée du premier puits (1) de chaleur, de sections (EQK1i) transversales individuelles des canaux (K1i) de refroidissement lui appartenant, du premier puits (1) de chaleur, au moyen d'un moyen de cloisonnement, qui recouvre au moins en partie les canaux (K1i) de refroidissement sur la face (E1) d'entrée du premier puits (1) de chaleur, réduite par rapport,
- à une deuxième section (Q2) transversale d'entrée, qui se compose, sur une face (E2) d'entrée du deuxième puits (2) de chaleur, de sections (EQK2i) transversales individuelles des canaux (K2i) de refroidissement lui appartenant, du deuxième puits (2) de chaleur,
**caractérisé en ce que**
le moyen de cloisonnement est conformé sous la forme d'un peigne (6) pour l'enfichage dans la face (E1) d'entrée du premier puits (1) de chaleur.

2. Agencement (KKA) de puits de chaleur suivant la revendication 1, dans lequel entre le premier puits (1) de chaleur et le deuxième puits (2) de chaleur, est interposé un espace (3) intermédiaire, qui est recouvert au moyen d'un recouvrement (4), dans lequel l'espace (3) intermédiaire et le recouvrement (4) forment une chambre de tourbillonnement.

3. Agencement (KKA) de puits de chaleur suivant la revendication 2, dans lequel des éléments de tourbillonnement et/ou conducteurs sont disposés dans l'espace (3) intermédiaire.

4. Agencement (20) de convertisseur pour l'alimentation d'une machine (M) électrique comprenant l'agencement (KKA) de puits de chaleur suivant l'une des revendications 1 à 3.

5. Agencement (20) de convertisseur suivant la revendication 4, prévu pour l'introduction verticale dans une armoire (24) de distribution, dans lequel un axe (21) longitudinal de l'agencement (KKA) de puits de chaleur est disposé verticalement et ainsi le sens (10) d'écoulement dans l'agencement (20) de convertisseur se crée parallèlement à l'axe (21) longitudinal, et une entrée (22) d'un fluide réfrigérant est disposée en bas sur la face (E1) d'entrée du premier puits (1) de chaleur et une sortie (23) du fluide (11) réfrigérant est disposée en haut sur la face de sortie opposée à la face (E2) d'entrée du deuxième puits (2) de chaleur.
